# EUROPÄISCHE PATENTSCHRIFT

(11) **EP 1 110 320 B1**
(45) Veröffentlichungstag und Bekanntmachung des Hinweises auf die Patenterteilung: **05.11.2003**
(21) Anmeldenummer: 99950496.2
(22) Anmeldetag: 02.08.1999
(51) Int. Cl.: H03K 19/003, H03K 17/16

(54) **AUSGANGSTREIBERSCHALTUNG**
OUTPUT DRIVING CIRCUIT
CIRCUIT D'ATTAQUE DE SORTIE

(30) Priorität: 18.08.1998 DE 19837394
(43) Veröffentlichungstag der Anmeldung: 27.06.2001
(73) Patentinhaber: Infineon Technologies AG, 81669 München (DE)
(72) Erfinder: KILLAT, Dirk, D-73230 Kirchheim (DE); HAASE, Ordwin, D-85521 Ottobrunn (DE); WERKER, Heinz, D-82386 Huglfing (DE)
(74) Vertreter: Barth, Stephan Manuel, Dr.
(86) Internationale Anmeldenummer: DE9902389
(87) Internationale Veröffentlichungsnummer: WO00011787

(56) Entgegenhaltungen:
- EP-A- 0 648 020

## Beschreibung

Die Erfindung betrifft eine Ausgangstreiberschaltung nach dem Oberbegriff von Patentanspruch 1, wie aus der US-A-4,992,676 bekannt, und eine differentielle Ausgangstreiberschaltung nach dem Oberbegriff von Patentanspruch 7.

Ausgangstreiberschaltungen werden in integrierten Schaltungen zum Treiben der Bausteinanschlüsse (Pins) verwendet. Aufgrund ständig steigender Betriebsfrequenzen von integrierten, digitalen Schaltungen werden die Anstiegs- und Abfallzeiten der Steuersignale, die die Ausgangstreiberschaltungen ansteuern, immer kürzer. Durch die hohen Schaltfrequenzen der digitalen Schaltungsteile treten auf den Versorgungsleitungen hochfrequente Stromimpulse auf. Insbesondere bei Ausgangstreiberschaltungen, die hohe Ströme zum Treiben von induktiven, resistiven oder kapazitiven Lasten liefern müssen, können diese unerwünschten Stromimpulse auf den Versorgungsleitungen beträchtliche Werte erreichen und damit andere Schaltungsteile in ihrer Funktion stören. Bei induktiven Lasten werden zudem durch abrupte Änderungen im Stromverlauf hohe Spannungsamplituden erzeugt, die elektromagnetisch unerwünschterweise die Funktion anderer Schaltungsteile beeinflußen können.

Zur Verringerung solcher Störungen wird versucht, beim Schalten von Ausgangstreiberschaltungen sowohl abrupte Änderungen im Stromverlauf der Ausgangstreiberschaltungen als auch Stromimpule auf den Versorgungsleitungen zu verringern. Bekannterweise werden dazu die großen Treibertransitoren einer Ausgangstreiberschaltung mit den dazugehörigen Ansteuerungen in Ketten von kleineren Treibertransistoren, sogenannten Treiberstufen, aufgeteilt und die einzelnen Treiberstufen der Kette zeitversetzt angesteuert. Dadurch werden zwar die Anstiegszeiten der Ausgangssignale verlängert, aber Stromimpulse und induzierte Störspannungen werden verringert.

In EP 0 340 731 B1 ist eine Ausgangstreiberschaltung beschrieben, bei der eine Vielzahl von Treiberstufen parallel geschaltet sind und durch den Treiberstufen vorgeschaltete RC-Glieder zeitversetzt angesteuert werden. Die RC-Glieder werden durch den Treibertransistoren vorgeschaltete Widerstände und die Gate-Source-Kapazität der einzelnen Treibertransistoren gebildet. Jedem Treibertransistor ist dabei eine spezifische Verzögerungszeit zugeordnet, die durch unterschiedliche Werte von R oder C einstellbar ist. Die Realisierung von Widerständen auf integrierten Schaltungen hat jedoch den Nachteil, daß der Flächenbedarf hoch ist und der absolute Wert des Widerstands schlecht einstellbar ist.

Aus US 4,992,676 ist eine Ausgangstreiberschaltung bekannt, bei der die einzelnen Treiberstufen zu einer Kette verschalten sind. Jede Treiberstufe der Kette wird dabei jeweils durch eine vorhergehende Treiberstufe angesteuert. Eine Verzögerung wird dabei durch die Signallaufzeit durch die jeweils einer Stufe vorhergehende Stufe bewirkt. Das Abschalten der Ausgangstreiberschaltung erfolgt jedoch für alle Treiberstufen parallel und gleichzeitig und führt damit zu einer abrupten Änderung im Stromverlauf und beispielweise bei einer angeschlossenen Induktivität zu einer induzierten Störspannung.

Eine weitere Ausgangstreiberschaltung, bei der zur Reduzierung von Strom- und spannungsspitzen bei Umschaltvorgängen ein RC-Glied zwischen einer ersten und einer zweiten Treiberstufe vorgesehen ist, ist aus US 5,355,029 bekannt. Das Abschalten der Treibertransistoren erfolgt hier jedoch ebenso parallel und gleichzeitig, wodurch die oben beschriebenen Nachteile beim Abschalten nicht beseitigt sind.

Der Erfindung liegt daher die Aufgabe zugrunde, eine Ausgangs-treiberschaltung anzugeben, die sowohl beim Anschalten als auch beim Abschalten der Treibertransistoren eine zeitliche Verzögerung zwischen den Treiberstufen vorsieht.

Diese Aufgabe wird durch eine Ausgangstreiberschaltung mit den Merkmalen von Patentanspruch 1 oder eine differentielle Ausgangstreiberschaltung mit den Merkmalen von Patentanspruch 7 gelöst. Vorteilhafte Ausgestaltungen der Erfindung ergeben sich aus den jeweiligen Unteransprüchen.

Eine Ausführungsform der Ausgangstreiberschaltung weist eine Vielzahl von paarweisen Treiberansteuerungen und Treiberschaltungen sowie eine Steuereinrichtung auf. Bei jedem Paar ist eine Treiberansteuerung mit einer Treiberschaltung verbunden und die Treiberansteuerungen sind in Reihe geschaltet mit einer Treiberansteuerung am Anfang und einer am Ende der Reihe. Die Steuereinrichtung wertet das Eingangssignal der Ausgangstreiberschaltung aus und schaltet in Abhängigkeit vom Ergebnis der Auswertung die Signallaufrichtung durch die Reihe von Treiberansteuerungen um. Das Eingangssignal wird dazu sowohl an die erste als auch an die letzte Treiberansteuerung geführt. Beim Anschalten der Ausgangstreiberstufe läuft das Eingangssignal von der ersten zur letzten Treiberstufe und beim Abschalten von der letzten Treiberstufe zur ersten. Aufgrund der Signallaufzeit durch eine einzelne Treiberstufe ergibt sich eine Verzögerung beim Schalten. Vorteilhafterweise wird dadurch sowohl ein verzögertes Anschalten als auch ein verzögertes Abschalten der Treiberstufen erreicht und in induktiven Lasten induzierte Störspannungen sowie Stromimpulse auf den Versorgungsleitungen verringert.

Erfindungsgemäß weisen die Treiberschaltungen unterschiedliche Stromtreiberfähigkeiten auf. Dabei kann beispielsweise die Stromtreiberfähigkeit von der ersten bis zur letzten Treiberstufe ansteigen. Vorteilhafterweise führt dann die Treiberschaltung der ersten Treiberstufe eine geringere Stromdichte als die Treiberschaltung der letzen Treiberstufe. Effekte wie beispielsweise Elektromigration aufgrund zu hoher Stromdichten in Leitungen werden dadurch abgeschwächt.

In einer bevorzugten Ausführungsform der Erfindung weist eine Treiberansteuerung mindestens eine Inverterschaltung und eine Vielzahl von Schaltern auf und ist mit Bauelementen der digitalen Schaltungstechnik einfach realisierbar. Zur Signalverzögerung in einer einzelnen Treiberansteuerung ist mindestens ein Kondensator vorgesehen, der zusätzlich zu den Inverterschaltungen zur Signalverzögerung dient. Vorteilhafterweise verlängern die Kondensatoren die Signallaufzeit durch die Treiberansteuerungen, so daß die Anstiegs- und Abfallzeit im Spannungs- und Stromverlauf verlängert werden kann.

In einer besonders bevorzugten Ausführungsform sind die Schalter der Treiberansteuerungen als Transistoren realisiert.

Bei einer besonders bevorzugten Ausführungsform der Ausgangstreiberschaltung wird diese in CMOS-Technologie hergestellt. Besonders vorteilhaft ist bei dieser Ausführungsform, daß die Schalter der Ausgangstreiberschaltung durch einzelne p- und n-Kanal-MOS-Transistoren realisiert werden können.

Eine bevorzugte Ausführungsform der Erfindung betrifft eine differentielle Ausgangstreiberschaltung, die zwei Ausgangstreiberschaltungen aufweist, deren Ausgänge kreuzweise verkoppelt sind. Besonders vorteilhaft erweist sich diese Ausführungsform zum Treiben induktiver Lasten wie beispielsweise Übertrager, da induzierte Spannungen durch verzögertes An- bzw. Abschalten der Ausgangssignale verringert werden und dadurch die Ausgangsanschlüsse der differentiellen Ausgangstreiberschaltung weniger belastet werden. Zudem werden elektromagnetische Störungen durch induzierte Spannungsspitzen verringert. Ein weiterer Vorteil des verzögerten An- und Abschaltens der Treiberschaltungen ergibt sich in einer verringerten Gleichtaktspannung. Dadurch verringert sich die Einstellzeit von Sender und Empfänger.

Weitere Vorteile, Merkmale und Anwendungsmöglichkeiten der Erfindung ergeben sich aus der nachfolgenden Beschreibung von Ausführungsbeispielen in Verbindung mit der Zeichnung. In der Zeichnung zeigen
- Fig.1: das Schaltbild eines Ausführungsbeispiels einer Ausgangstreiberschaltung;
- Fig.2A: das Schaltbild eines Ausführungsbeispiels einer Treiberansteuerung;
- Fig.2B: das Schaltbild eines Ausführungsbeispiels einer Treiberschaltung; und
- Fig.3: die Kombination zweier Ausgangstreiberschaltungen zu einer Ausgangstreiberschaltung für die digitale Signalübertragung.

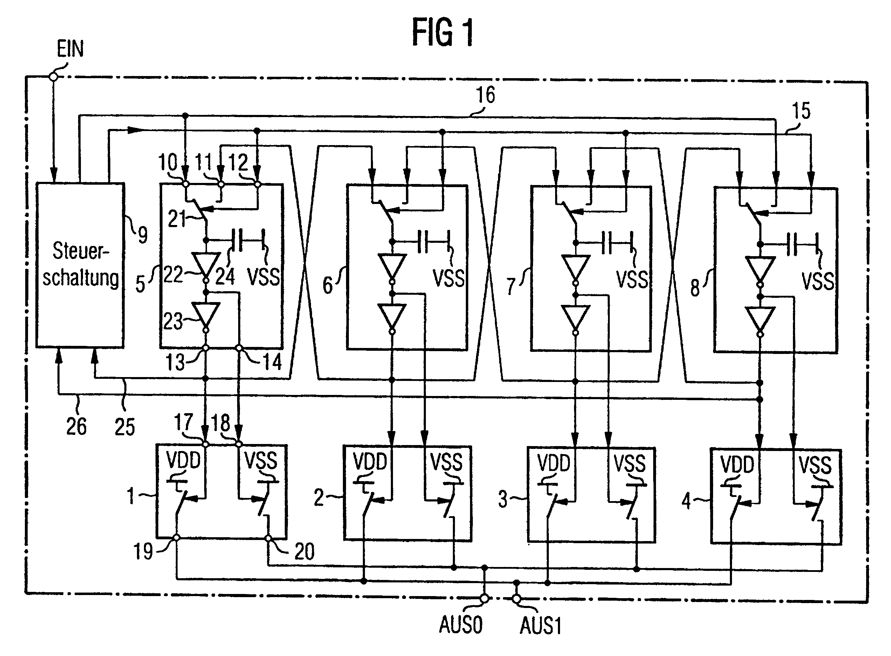

Fig.1 zeigt eine Ausgangstreiberschaltung mit einem digitalen Eingang EIN sowie zwei Ausgängen AUS0 und AUS1. Der Ausgang AUS0 kann abgeschaltet werden oder auf die zweite Versorgungsspannung VSS der Ausgangstreiberschaltung geschaltet werden. In der digitalen Schaltungstechnik ist VSS häufig identisch mit dem Nullpotential. Bekannterweise wird ein solcher Ausgang auch als Pull-Down-Ausgang bezeichnet. Der Ausgang AUS1 kann ebenfalls abgeschaltet werden oder auf die erste Versorgungsspannung VDD der Ausgangstreiberschaltung geschaltet werden. Ist VDD identisch mit dem High-Potential in der digitalen Schaltungstechnik, wird der Ausgang auch bekannterweise als Pull-Up-Ausgang bezeichnet.

Die Ausgangstreiberschaltung weist vier Treiberschaltungen 1, 2, 3 und 4 auf, die jeweils zwei Eingänge 17 und 18 sowie zwei Ausgänge 19 und 20 aufweisen. Der Ausgang 19 jeder Treiberschaltung ist mit dem Ausgang AUS1 verbunden und der Ausgang 20 mit dem Ausgang AUS0. Im dargestellten Ausführungsbeispiel weist jede Treiberschaltung zwei Schalter auf, wobei ein erster Schalter den Ausgang 19 mit der ersten Versorgungsspannung VDD verbindet und ein zweiter Schalter den Ausgang 20 mit der zweiten Versorgungsspannung VSS verbindet. Der erste Schalter wird über den Eingang 17 und der zweite Schalter über den Eingang 18 der Treiberschaltung digital angesteuert, wobei beide Schalter durch logische Zustände ein- bzw. ausgeschaltet werden. Bevorzugt wird bei einer logischen Null am Eingang 17 der erste Schalter geschlossen, wohingegen der zweite Schalter durch eine logische Eins am Eingang 18 geschlossen wird.

Die Treiberschaltungen sind paarweise mit Treiberansteuerungen 5, 6, 7 und 8 zu einer Treiberstufe verbunden, wobei jeweils der Ausgang 13 einer Treiberansteuerung mit dem Eingang 17 einer Treiberschaltung und der Ausgang 14 einer Treiberansteurung mit dem Eingang 18 einer Treiberschaltung verbunden ist. Jede Treiberansteuerung weist zwei Inverterschaltungen 22 und 23, einen Kondensator 24 und einen Umschalter 21 auf. Die Inverterschaltungen in Kombination mit dem Kondensator 24 dienen zur Signalverzögerung in der Treiberansteuerung, wobei die Signalverzögerung durch weitere Kondensatoren und Inverschaltungen vergrößert werden kann. Die Dimensionierung der Inverterschaltungen, insbesondere der Treiberfähigkeit, ist dabei auf die jeweils anzusteuernde Treiberschaltung abgestimmt, so daß die Zeitverzögerung beim Schalten der anzusteuernden Treiberschaltung für jede Treiberstufe gleich ist. Der Umschalter, der über den Umschalteingang 12 der Treiberansteuerung gesteuert wird, schaltet zwischen dem Eingang 10 und dem Eingang 11 der Treiberansteuerung um. Wechselseitig ist somit einer der beiden Eingänge 10 und 11 mit dem Eingang des ersten Inverters 22 verbunden.

Die Treiberansteuerungen sind in Reihe geschalten, wobei der erste Eingang 10 der ersten Treiberansteuerung 5 und der zweite Eingang 11 der letzten Treiberansteuerung 8 der Reihe über eine Leitung 16 mit einer Steuereinrichtung 9 verbunden sind. Über eine Leitung 15 ist der Umschalteingang 12 jeder Treiberansteuerung mit der Steuereinrichtung verbunden. Zusätzlich ist über eine Leitung 25 bzw. 26 der erste Ausgang der ersten Treiberansteuerung 5 bzw. letzten Treiberansteuerung 8 mit der Steuereinrichtung verbunden. Ausgehend von der ersten Treiberansteuerung 5 ist jede Treiberansteuerung 6 bis 8 mit der jeweils folgenden Treiberansteuerung so verbunden, daß der erste Ausgang 13 einer Treiberansteuerung mit dem ersten Eingang 10 der folgenden Treiberansteuerung verbunden ist. Ausgehend von der letzten Treiberansteuerung 8 ist der erste Ausgang 13 jeder Treiberansteuerung mit dem zweiten Eingang 11 der jeweils vorhergehenden Treiberansteuerung verbunden. Die Steuereinrichtung ist mit dem Eingang EIN der Ausgangstreiberschaltung verbunden.

Die Funktion der Ausgangstreiberschaltung wird im folgenden beschrieben. Liegt am digitalen Eingang EIN eine logische Eins an, so soll der Pull-Up-Ausgang AUS1 und der Pull-Down-Ausgang AUSO eingeschaltet werden. Die Steuereinrichtung schaltet in Abhängigkeit vom Eingangssignal EIN die Signallaufrichtung durch die Reihe von Treiberansteuerungen um. Beim Einschalten der beiden Ausgänge AUS0 und AUS1 wird jeweils auf den ersten Eingang jeder Treiberansteuerung umgeschaltet, so daß das Eingangssignal durch die erste Treiberansteuerung 5, die zweite Treiberansteuerung 6 bis zur letzten Treiberansteuerung 8 alle Treiberansteuerungen der Reihe durchläuft. Dadurch werden die Treiberschaltungen zeitversetzt angeschaltet und die Stromtreiberfähigkeit am Ausgang AUS0 und AUS1 steigt langsam stufenweise an. Ein Spannungssprung in einer angeschlossenen Induktivität aufgrund einer schnellen Stromänderung mit den in der Beschreibungseinleitung geschilderten Nachteilen wird somit verringert. Wird nun das Eingangssignal auf logisch Null geschaltet, sollen beide Ausgänge AUS0 und AUS1 abgeschaltet werden. Die Steuereinrichtung schaltet hierzu jeweils auf die zweiten Eingänge jeder Treiberansteuerung um, so daß zuerst die letzte Treiberansteuerung 8 schaltet, dann die vorletzte Treiberansteuerung 7 und zuletzt die erste Treiberansteuerung 5. Dabei werden die Ausgangsstufen zeitversetzt abgeschaltet und die Stromtreiberfähigkeit sinkt an den Ausgängen langsam ab.

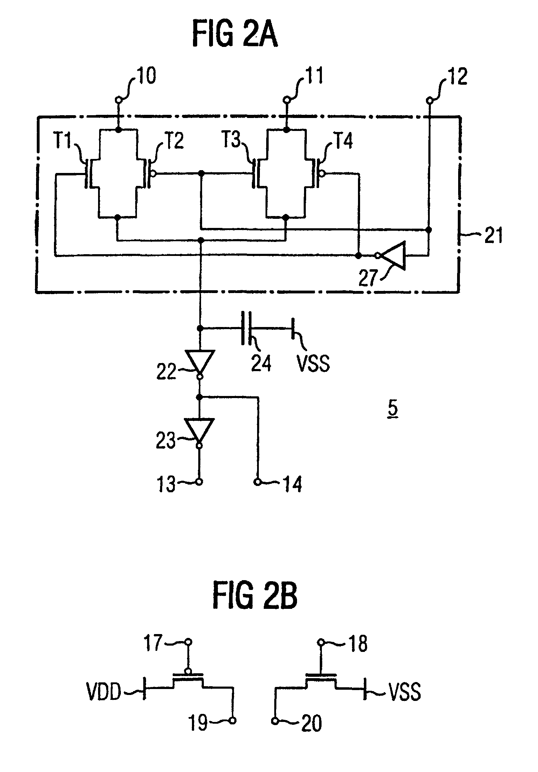

In Fig.2A ist ein Ausführungsbeispiel der Treiberansteuerung in CMOS-Schaltungstechnik dargestellt. Der Umschalter 21 ist bei diesem Beispiel durch Transistoren T1, T2, T3 und T4 realisiert, die zu sogenannten Transfer- oder Transmission-Gates verschaltet sind. Das durch die Transistoren T1 und T2 gebildete Transfer-Gate schaltet den ersten Eingang 10 und das durch die Transistoren T3 und T4 gebildete Transfer-Gate schaltet den zweiten Eingang 11. Der Umschalteingang 12 ist mit den Steueranschlüssen der Transistoren T2 und T3 und über einen Inverter 27 mit den Steueranschlüssen der Transistoren T1 und T4 verbunden. Die Ausgänge beider Transfer-Gates sind mit dem Eingang eines ersten Inverters 22 und einem Kondensator 24 verbunden. Mit dem ersten Inverter ist ein zweiter Inverter 23 verbunden, dessen Ausgang den ersten, nichtinvertierten Ausgang 13 der Treiberansteuerung bildet. Der zweite, invertierte Ausgang 14 der Treiberansteuerung ist mit dem Ausgang des ersten Inverters 22 verbunden. Der Kondensator 23 und der erste und zweite Inverter verzögern das Ansteuersignal für die Treiberschaltung, die über die Augänge 13 und 14 angesteuert wird. Je nach Wahl des Kondensators und der Inverter kann die Laufzeit des Ansteuersignals und damit die An- und Abschaltverzögerung der mit der Treiberansteuerung verbundenen Treiberschaltung eingestellt werden.

Fig.2B zeigt ein Ausführungsbeispiel der Treiberschaltung, die als Schalter zwei MOS-Transistoren in CMOS-Technologie aufweist, wobei die Laststrecke des p-Kanal-MOSFET's zwischen der ersten Versorgungsspannung VDD und dem Ausgang 19 und die Laststrecke des n-Kanal-MOSFET's zwischen der zweiten Versorgungsspannung VSS und dem Ausgang 20 geschalten ist.

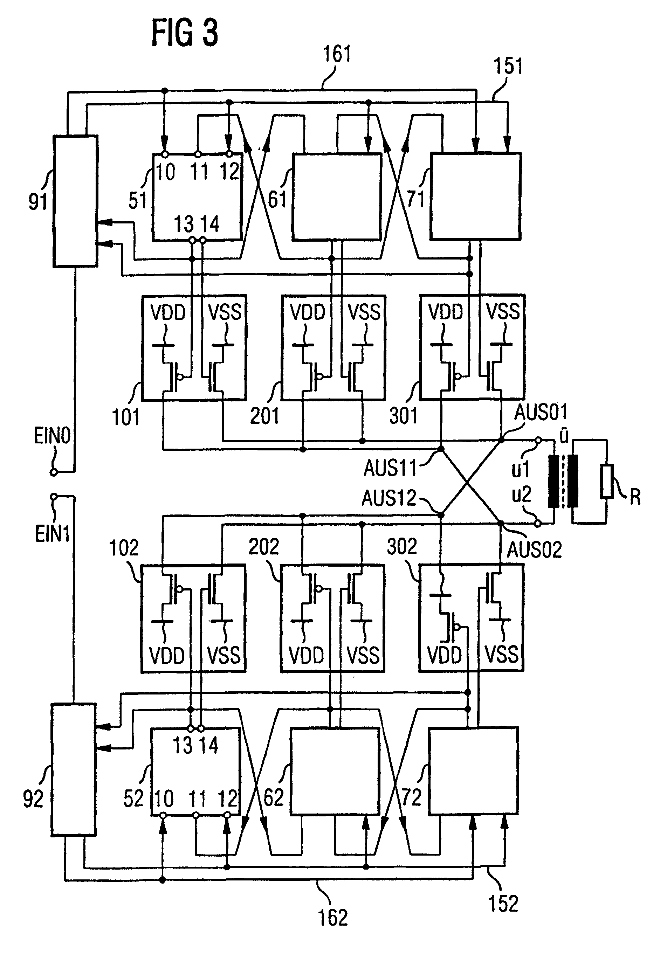

Fig.3 zeigt eine Kombination zweier Ausgangstreiberschaltungen, wobei eine erste Ausgangstreiberschaltung eine Steuereinrichtung 91, drei Treiberansteuerungen 51, 61 und 71 und drei Treiberschaltungen 101, 201 und 301 aufweist. Eine solche Anordnung wird beispielsweise in einem UPN-Sender mit differentiellen Ausgängen, der in ISDN-Bausteinen angewendet wird, zur Ansteuerung von Übertragern eingesetzt. Eine zweite Ausgangstreiberschaltung weist eine Steuereinrichtung 92, drei Treiberschaltungen 52, 62 und 72 sowie drei Treiberschaltungen 102, 202 und 302 auf. Über die Leitung 151 bzw. 152 schaltet die Steuereinrichtung 91 bzw. 92 die Eingänge der Treiberansteuerungen 51, 61 und 71 bzw. 52, 62 und 72 um. Die Leitung 161 bzw. 162 verbindet wiederum den ersten Eingang der ersten Treiberansteuerung 51 bzw. 51 und den zweiten Eingang der letzten Treiberansteuerung 71 bzw. 72 mit der Steuereinrichtung 91 bzw. 92. Der Pull-Up-Ausgang AUS11 der ersten Ausgangstreiberschaltung ist mit dem Pull-Down-Ausgang AUS02 der zweiten Ausgangstreiberschaltung und dem Anschluß U2 eines Übertragers Ü verbunden. Der Pull-Down-Ausgang AUS01 der ersten Ausgangstreiberschaltung ist mit dem Pull-Up-Ausgang AUS12 der zweiten Ausgangstreiberschaltung und dem Anschluß U1 eines Übertragers Ü verbunden. Der Übertrager ist auf seiner Sekundärseite mit einem Lastwiderstand RL verbunden. Durch Anlegen verschiedener Eingangssignalkombinationen kann nun der Übertrager Ü durch die beiden Ausgangstreiberschaltungen getrieben werden. Dabei führen die folgenden Eingangssignalkombinationen (EIN0, EIN1) zu den entsprechenden Spannungen an den Anschlüssen (U1, U2) des Übertragers ("aus" bedeutet, daß der Ausgang abgeschaltet ist und das Potential an diesem Ausgang unbestimmt ist):

| (EIN0, EIN1) | (AUS01, AUS12) | (AUS02, AUS11) | (U1, U2) |
|---|---|---|---|
| (1, 1) | (VSS, VDD) | (VSS, VDD) | verbotener Zustand |
| (1, 0) | (VSS, aus) | (aus, VDD) | (VSS, VDD) |
| (0, 1) | (aus, VDD) | (VSS, aus) | (VDD, VSS) |
| (0, 0) | (aus, aus) | (aus, aus) | (aus, aus) |

Die Eingangssignalkombination (1, 1) ist verboten, da dabei alle Schalter geschlossen werden und die erste VDD und zweite VSS Versorgungsspannung kurzgeschlossen sind. Die Treiberschaltungen können dabei durch einen hohen Strom, der über die Schalter fließt, beschädigt werden. Mit der Eingangssignalkombination (0, 0) werden die Ausgänge komplett abgeschaltet, so daß das Potential an den Anschlüssen U1 und U2 des Übertragers unbestimmt ist. In diesem Zustand fließt durch die Treiberschaltungen kein Strom. Dadurch, daß beim Übergang von der Eingangssignalkombination (1, 0) zu (0, 1) bzw. (0, 1) zu (1,0) die Treiberschaltungen 101, 201, 301 und 102, 202, 302 zeitversetzt ein- bzw. abgeschaltet werden, wird ein Gleichtaktimpuls beim Einschalten und eine Gleichtaktspannung beim Ausschalten auf der Primärseite des Übertragers deutlich verringert. Zudem wird durch das zeitversetzte Abschalten der Treiberschaltungen eine in dem Übertrager induzierte Spannungsüberhöhung verringert und dadurch das elektromagnetische Verhalten der Schaltung verbessert.

Die Stromtreiberfähigkeit der Treiberschaltungen ist überlicherweise unterschiedlich groß. Dabei weist die mit der ersten Treiberansteuerung 51, 52 verbundene Treiberschaltung 101, 102 eine niedrigere Stromtreiberfähigkeit als die mit der letzten Treiberansteuerung 71, 72 verbunden Treiberschaltung 301, 302 auf. Beim Ein- bzw. Abschalten der Treiberschaltungen wird dann die schwächste 101, 102 bzw. stärkste 301, 302 Treiberschaltung zuerst ein- bzw. abgeschaltet. Diese Maßnahme verringert zusätzlich eine in dem Übertrager beim Ein- bzw. Abschalten der Treiberschaltungen induzierte Spannung. Zudem wird dadurch vermieden, daß die ersten Treiberstufen 101, 102 beim Einschalten eine sehr hohe Stromdichte führt, die Elektromigration in den Transistoren und Leitungen der Treiberschaltung der ersten Treiberstufe begünstigen kann.

Die Steuereinrichtungen 91, 92 weisen Logikelemente zur Auswertung der Eingangssignale auf, die ein Umschaltsignal erzeugen, das über die Leitungen 151, 152 die Signallaufrichtung durch die Reihe von Treiberansteuerungen umschalten. Es müssen lediglich die in der vorhergehenden Tabelle beschriebenen Eingangskombination ausgewertet werden und daraus Signale zum Umschalten der beiden Eingänge 10 und 11 der Treiberansteuerungen abgeleitet werden. Dies kann beispielsweise durch ein einfaches Schaltnetz, das lediglich aus logische Gattern besteht, ausgeführt werden.

## Patentansprüche

1. Ausgangstreiberschaltung einer integrierten Schaltung, die einen Eingangsanschluß (EIN) zum Empfangen eines Eingangssignals, mindestens einen Ausgangsanschluß (AUS0, AUS1) zum Abgeben eines Ausgangssignals sowie eine Vielzahl von Treiberstufen (1, 5; 2, 6; 3, 7; 4, 8) aufweist, wobei jede Treiberstufe eine Treiberschaltung und eine Treiberansteuerung aufweist und ein Ansteuersignal (13) der Treiberansteuerung die Treiberschaltung ansteuert,
**dadurch gekennzeichnet, daß**
- jede Treiberansteuerung einen ersten (10) und zweiten (11) Eingang aufweist, wobei der erste oder zweite Eingang abhängig von einem Umschaltsignal aktiviert ist;
- die Treiberansteuerungen hintereinander in Reihe geschaltet sind, wobei ausgehend von der ersten Treiberansteuerung (5) der Reihe das Ansteuersignal jeder Treiberansteuerung dem ersten Eingang jeder folgenden Treiberansteuerung zugeführt ist und ausgehend von der letzten Treiberansteuerung (8) der Reihe das Ausgangssignal jeder Treiberansteuerung dem zweiten Eingang jeder vorhergehenden Treiberansteuerung zugeführt ist;
- die Ausgangstreiberschaltung eine Steuereinrichtung (9) aufweist, die über eine Umschaltleitung (15) das Umschaltsignal an jede Treiberansteuerung überträgt;
- der erste Eingang der ersten Treiberansteuerung und der zweite Eingang der letzten Treiberansteuerung der Reihe mit der Steuereinrichtung über eine Eingangsleitung (16) verbunden ist, die ein gegenüber dem Eingangsanschluß (EIN) verzögertes Eingangssignal überträgt;
- die Steuereinrichtung zwischen dem ersten und zweiten Eingang jeder Treiberansteuerung umschaltet; und
- die Treiberschaltungen unterschiedliche Stromtreiberfähigkeiten aufweisen.

2. Ausgangstreiberschaltung nach Anspruch 1,
**dadurch gekennzeichnet, daß**
jede Treiberansteuerung eine Vielzahl von parallel geschalteten Schaltern (T1, T2; T3, T4), mindestens eine Inverterschaltung (22, 23) und mindestens einen Kondensator (24) aufweist.

3. Ausgangstreiberschaltung nach einem der vorhergehenden Ansprüche,
**dadurch gekennzeichnet, daß**
in der Treiberansteuerung Transistoren (T1, T2, T3, T4) als Schalter vorgesehen sind.

4. Ausgangstreiberschaltung nach einem der vorhergehenden Ansprüche,
**dadurch gekennzeichnet, daß**
jede Treiberansteuerung zusätzlich ein invertiertes Ansteuersignal (14) abgibt.

5. Ausgangstreiberschaltung nach Anspruch 4,
**dadurch gekennzeichnet, daß**
jede Treiberschaltung das Ansteuersignal (13) und das komplementäre Ansteuersignal (14) empfängt.

6. Ausgangstreiberschaltung nach einem der vorhergehenden Ansprüche,
**dadurch gekennzeichnet, daß**
die Ausgangstreiberschaltung in CMOS-Technologie ausgeführt ist.

7. Differentielle Ausgangstreiberschaltung,
**gekennzeichnet durch** eine erste und zweite Ausgangstreiberschaltung nach einem der Patentansprüche 1 bis 6, wobei die Ausgänge (AUS01, AUS11) der ersten Ausgangstreiberschaltungen mit den Ausgängen (AUS02, AUS12) der zweiten Ausgangstreiberschaltung kreuzweise verkoppelt sind.

## Claims

1. Output driver circuit of an integrated circuit having an input terminal (IN) for receiving an input signal, at least one output terminal (OUT0, OUT1) for outputting an output signal, and also a multiplicity of driver stages (1, 5; 2, 6; 3, 7; 4, 8), each driver stage having a driver circuit and a driver activation arrangement and an activation signal (13) of the driver activation arrangement activating the driver circuit,
**characterized in that**
- each driver activation arrangement has a first (10) and second (11) input, the first or second input being activated depending on a changeover signal;
- the driver activation arrangements are cascaded in series, in which case, proceeding from the first driver activation arrangement (5) of the series, the activation signal of each driver activation arrangement is fed to the first input of each subsequent driver activation arrangement and, proceeding from the last driver activation arrangement (8) of the series, the output signal of each driver activation arrangement is fed to the second input of each preceding driver activation arrangement;
- the output driver circuit has a control device (9), which transmits the changeover signal to each driver activation arrangement via a changeover line (15);
- the first input of the first driver activation arrangement and the second input of the last driver activation arrangement of the series is connected to the control device via an input line (16), which transmits a delayed input signal by comparison with the input terminal (IN);
- the control device changes over between the first and second inputs of each driver activation arrangement
- the driver circuits have different current driver capabilities.

2. Output driver circuit according to Claim 1 or 2,
**characterized in that**
each driver activation arrangement has a multiplicity of switches (T1, T2; T3, T4) connected in parallel, at least one inverter circuit (22, 23) and at least one capacitor (24).

3. Output driver circuit according to one of the preceding claims,
**characterized in that**
in the driver activation arrangement, transistors (T1, T2, T3, T4) are provided as switches.

4. Output driver circuit according to one of the preceding claims,
**characterized in that**
each driver activation arrangement additionally outputs an inverted activation signal (14).

5. Output driver circuit according to Claim 5,
**characterized in that**
each driver circuit receives the activation signal (13) and the complementary activation signal (14).

6. Output driver circuit according to one of the preceding claims,
**characterized in that**
the output driver circuit is embodied using CMOS technology.

7. Differential output driver circuit,
**characterized by** a first and second output driver circuit according to one of patent Claims 1 to 6, the outputs (OUT01, OUT11) of the first output driver circuits being cross-coupled to the outputs (OUT02, OUT12) of the second output driver circuit.

## Revendications

1. Circuit d'attaque de sortie d'un circuit intégré qui comprend une borne (EIN) d'entrée pour recevoir un signal d'entrée, au moins une borne (AUS0, AUS1) de sortie pour délivrer un signal de sortie, ainsi qu'une pluralité d'étages (1, 5 ; 2, 6 ; 3, 7 ; 4, 8) d'attaque, où chaque étage d'attaque comprend un circuit d'attaque et un élément de commande d'attaque et un signal (13) de commande de l'élément de commande d'attaque commande le circuit d'attaque, **caractérisé en ce que**
- chaque élément de commande d'attaque comprend une première (10) et une deuxième (11) entrée, où la première ou la deuxième entrée est activée en fonction d'un signal de commutation ;
- les éléments de commande d'attaque sont branchés en série les uns après les autres, où en partant du premier élément (5) de commande d'attaque de la série, le signal de commande de chaque élément de commande d'attaque est amené à la première entrée de chaque élément suivant de commande d'attaque, et, en partant du dernier élément (8) de commande d'attaque de la série, le signal de sortie de chaque élément de commande d'attaque est amené à la deuxième entrée de chaque élément précédent de commande d'attaque ;
- le circuit d'attaque de sortie comprend un dispositif (9) de commande qui transmet le signal de commutation à chaque élément de commande d'attaque par l'intermédiaire d'une ligne (15) de commutation ;
- la première entrée du premier élément de commande d'attaque et la deuxième entrée du dernier élément de commande d'attaque de la série sont reliés au dispositif de commande par l'intermédiaire d'une ligne (16) d'entrée qui transmet un signal d'une ligne (16) d'entrée qui transmet un signal d'entrée retardé par rapport à la borne (EIN) d'entrée ;
- le dispositif de commande commute entre la première et la deuxième entrée de chaque élément de commande d'attaque ; et
- les circuits d'attaque comprennent des aptitudes différentes d'attaque en courant.

2. Circuit d'attaque de sortie selon la revendication 1, **caractérisé en ce que**
chaque élément de commande d'attaque comprend une pluralité de commutateurs (T1, T2, T3, T4) branchés en parallèle, au moins un circuit inverseur (22, 23) et au moins un condensateur (24).

3. Circuit d'attaque de sorite selon l'une des revendications précédentes, **caractérisé en ce que**
des transistors (T1, T2, T3, T4) sont prévus dans P' élément de commande d'attaque en tant que commutateurs.

4. Circuit d'attaque de sortie selon l'une des revendications précédentes, **caractérisé en ce que**
chaque élément de commande d'attaque délivre en outre un signal inversé (14) de commande.

5. Circuit d'attaque de sortie selon la revendication 4, **caractérisé en ce que**
chaque circuit d'attaque reçoit le signal (13) de commande et le signal complémentaire (14) de commande.

6. Circuit d'attaque de sortie selon l'une des revendications précédentes, **caractérisé en ce que**
le circuit d'attaque de sortie est réalisé en technologie CMOS.

7. Circuit différentiel d'attaque de sortie,
**caractérisé par** un premier et un deuxième circuit d'attaque de sortie selon l'une des revendications 1 à 6, dans lequel les sorties (AUS01, AUS11) du premier circuit d'attaque de sortie sont couplées de manière croisée aux sorties (AUS02, AUS12) du deuxième circuit d'attaque de sortie.
